# EUROPEAN PATENT APPLICATION

(11) **EP 2 445 016 A1**
(43) Date of publication of application: **25.04.2012**
(21) Application number: 10789412.3
(22) Date of filing: 09.06.2010
(51) Int. Cl.: H01L 31/068

(54) **BACK ELECTRODE TYPE SOLAR CELL, SOLAR CELL PROVIDED WITH WIRING SHEET, AND SOLAR CELL MODULE**

(30) Priority: 18.06.2009 JP 2009145617
(71) Applicant: Sharp Kabushiki Kaisha, Osaka-shi, Osaka 545-8522 (JP)
(72) Inventor: DOTTA, Yoshihisa, Osaka 545-8522 (JP); SAINOO, Yasushi, Osaka 545-8522 (JP); TSUNEMI, Akiko, Osaka 545-8522 (JP); NISHINA, Tomohiro, Osaka 545-8522 (JP)
(74) Representative: Müller-Boré & Partner Patentanwälte
(86) International application number: PCT/JP2010/059757
(87) International publication number: WO 2010/147037

(57) **Abstract**

There is provided a back electrode type solar cell (8) including a semiconductor substrate (1), and an electrode for first conduction type (6) and an electrode for second conduction type (7) disposed on one surface side of the semiconductor substrate (1), a center (2b) in a width direction of a first contact region (2a), which is a region of the semiconductor substrate (1) with which the electrode for first conduction type (6) is in contact, being shifted in position from a center in a width direction of the electrode for first conduction type (6). There is also provided a solar cell with an interconnection sheet using the back electrode type solar cell (8), and a solar cell module using the back electrode type solar cell (8).

## Description

### TECHNICAL FIELD

The present invention relates to a back electrode type solar cell, a solar cell with an interconnection sheet, and a solar cell module.

### BACKGROUND ART

Development of clean energy has recently been desired in view of the problem of exhaustion of energy resources and the global environment problem such as increase of CO₂ in the air, and photovoltaic power generation employing particularly solar cells among semiconductor devices has been developed and put into practice as a new energy source, and is now on the way to progress.

A double-sided electrode type solar cell has been a conventional mainstream solar cell, which includes for example a monocrystalline or polycrystalline silicon substrate having a light receiving surface having an impurity of a conduction type opposite to that of the silicon substrate diffused therein to provide a pn junction, and electrodes provided at the light receiving surface of the silicon substrate and a surface opposite to the light receiving surface, respectively. In the double-sided electrode type solar cell, it is also generally done to diffuse an impurity of the same conduction type as the silicon substrate in the silicon substrate at the back surface at a high concentration to provide high output by a back surface field effect.

Research and development has also proceeded of a solar cell provided with an interconnection sheet (a solar cell with an interconnection sheet) configured by disposing, on the interconnection sheet, a back electrode type solar cell having an electrode formed only on a back surface of a silicon substrate without having an electrode formed on a light receiving surface of the silicon substrate (see, for example, Patent Literature 1 (Japanese Patent Laying-Open No. 2005-340362) and the like).

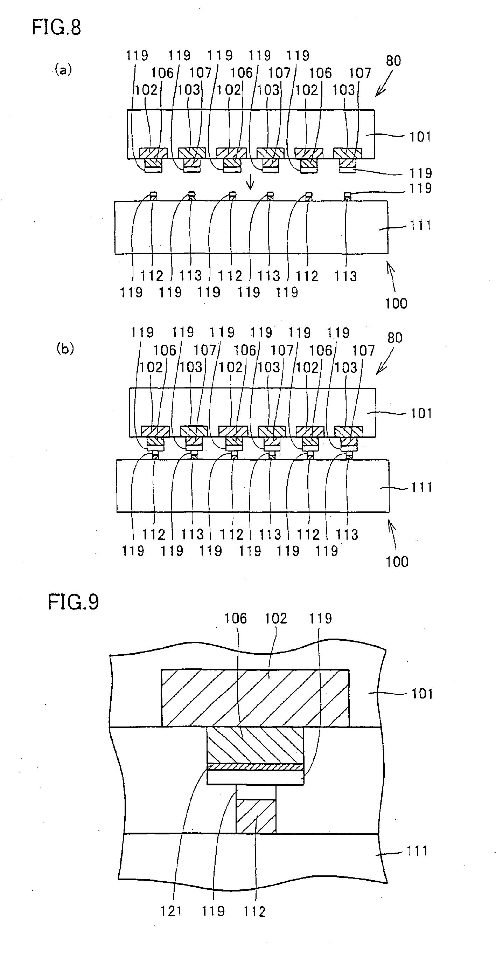

A conventional method for manufacturing a solar cell with an interconnection sheet will be described hereinafter with reference to schematic cross-sectional views in Figs. 8(a) and (b).

First, as shown in Fig. 8(a), a back electrode type solar cell 80 is disposed on an interconnection sheet 100.

Solder 119 formed on a surface of a silver electrode for p type 106 that is in contact with a p+ layer 102 on a back surface of an n-type silicon substrate 101 of back electrode type solar cell 80 is disposed on solder 119 formed on a surface of a p wiring 112 formed on a glass epoxy board 111 of interconnection sheet 100, and solder 119 formed on a surface of a silver electrode for n type 107 that is in contact with an n+ layer 103 on the back surface of n-type silicon substrate 101 of back electrode type solar cell 80 is disposed on solder 119 formed on a surface of an n wiring 113 formed on glass epoxy board 111 of interconnection sheet 100.

Then, by blowing heated air from the back electrode type solar cell 80 side to melt both solder 119, and then, cooling solder 119, silver electrode for p type 106 of back electrode type solar cell 80 and p wiring 112 of interconnection sheet 100 are connected by solder 119, and silver electrode for n type 107 of back electrode type solar cell 80 and n wiring 113 of interconnection sheet 100 are connected by solder 119 as shown in Fig. 8(b). As a result, back electrode type solar cell 80 and interconnection sheet 100 are integrated. The solar cell with the interconnection sheet is thus fabricated.

The solar cell with the interconnection sheet fabricated as described above is sealed in a transparent resin such as EVA (ethylene vinyl acetate) to form into a solar cell module.

### CITATION LIST

### PATENT LITERATURE

PTL 1: Japanese Patent Laying-Open No. 2005-340362

### SUMMARY OF INVENTION

### TECHNICAL PROBLEM

However, in the case where tin-containing solder such as Sn-Bi-based solder is used as solder 119, tin diffuses from solder 119 into silver electrode for p type 106 and silver electrode for n type 107 due to, for example, an increase in temperature of the solar cell module caused by heat generated at the time of driving the solar cell module and solar heat. As a result, as shown in Fig. 9, for example, an alloy layer 121 of silver and tin is formed on the surface of silver electrode for p type 106.

When diffusion of tin further proceeds and alloy layer 121 of silver and tin reaches a contact region, which is a region where silver electrode for p type 106 is in contact with p+ layer 102 on the back surface of n-type silicon substrate 101, contact resistance between silver electrode for p type 106 and p+ layer 102 increases. This leads to a reduction in properties of the solar cell with the interconnection sheet and the solar cell module.

Fig. 9 shows only the case of silver electrode for p type 106. It is needless to say, however, that a similar phenomenon occurs at silver electrode for n type 107 as well.

Since alloy layer 121 of silver and tin formed due to diffusion of tin as described above expands rapidly, it has been desired to ensure the reliability of the solar cell module for a longer time.

In light of the above-mentioned circumstances, an object of the present invention is to provide a back electrode type solar cell capable of ensuring the reliability of a solar cell module for a longer time, a solar cell with an interconnection sheet, and a solar cell module.

### SOLUTION TO PROBLEM

The present invention is directed to a back electrode type solar cell, including: a semiconductor substrate; and an electrode for first conduction type and an electrode for second conduction type disposed on one surface side of the semiconductor substrate, a center in a width direction of a first contact region, which is a region of the semiconductor substrate with which the electrode for first conduction type is in contact, being shifted in position from a center in a width direction of the electrode for first conduction type.

Preferably, in the back electrode type solar cell according to the present invention, a center in a width direction of a second contact region, which is a region of the semiconductor substrate with which the electrode for second conduction type is in contact, is shifted in position from a center in a width direction of the electrode for second conduction type.

In addition, the present invention is directed to a solar cell with an interconnection sheet, including: a back electrode type solar cell; and an interconnection sheet, the back electrode type solar cell including a semiconductor substrate, and an electrode for first conduction type and an electrode for second conduction type disposed on one surface side of the semiconductor substrate, the interconnection sheet including an insulating base material, and a wiring for first conduction type and a wiring for second conduction type disposed on one surface side of the insulating base material, a tin-containing solder layer being disposed in a region other than a region corresponding to at least one of a first contact region, which is a region of the semiconductor substrate with which the electrode for first conduction type is in contact, and a second contact region, which is a region of the semiconductor substrate with which the electrode for second conduction type is in contact.

Preferably, in the solar cell with the interconnection sheet according to the present invention, a shortest distance in a width direction between the first contact region and the tin-containing solder layer is not less than three times as long as a shortest distance in a height direction between the first contact region and a vertex of the silver electrode for first conduction type.

Preferably, in the solar cell with the interconnection sheet according to the present invention, a shortest distance in a width direction between the second contact region and the tin-containing solder layer is not less than three times as long as a shortest distance in a height direction between the second contact region and a vertex of the silver electrode for second conduction type.

In addition, the present invention is directed to a solar cell with an interconnection sheet, including: a back electrode type solar cell; and an interconnection sheet, the back electrode type solar cell including a semiconductor substrate, and an electrode for first conduction type and an electrode for second conduction type disposed on one surface side of the semiconductor substrate, the interconnection sheet including an insulating base material, and a wiring for first conduction type and a wiring for second conduction type disposed on one surface side of the insulating base material, a center in a width direction of a tin-containing solder layer that is in contact with the electrode for first conduction type and the electrode for second conduction type being shifted in position from a center in a width direction of at least one of the electrodes.

Preferably, in the solar cell with the interconnection sheet according to the present invention, the center in the width direction of the tin-containing solder layer that is in contact with the electrode for first conduction type is shifted in position from the center in the width direction of the electrode for first conduction type, and a position of a center in a width direction of a first contact region, which is a region of the semiconductor substrate that is in contact with the electrode for first conduction type, is shifted opposite to the tin-containing solder layer.

Preferably, in the solar cell with the interconnection sheet according to the present invention, the center in the width direction of the tin-containing solder layer that is in contact with the electrode for second conduction type is shifted in position from the center in the width direction of the electrode for second conduction type, and a position of a center in a width direction of a second contact region, which is a region of the semiconductor substrate that is in contact with the electrode for second conduction type, is shifted opposite to the tin-containing solder layer.

Preferably, in the solar cell with the interconnection sheet according to the present invention, the tin-containing solder layer includes at least tin and bismuth.

Furthermore, the present invention is directed to a solar cell module including any one of the solar cells with the interconnection sheet as described above.

### ADVANTAGEOUS EFFECTS OF INVENTION

According to the present invention, there can be provided a back electrode type solar cell capable of ensuring the reliability of a solar cell module for a longer time, a solar cell with an interconnection sheet, and a solar cell module.

### BRIEF DESCRIPTION OF DRAWINGS

Fig. 1 is a schematic cross-sectional view of one example of a solar cell module according to the present invention.
Fig. 2(a) is a schematic enlarged cross-sectional view of a silver electrode for first conduction type of a back electrode type solar cell shown in Fig. 1 and therearound, and Fig. 2(b) is a schematic enlarged cross-sectional view of a silver electrode for second conduction type of the back electrode type solar cell shown in Fig. 1 and therearound.
Figs. 3(a) to (g) are schematic cross-sectional views illustrating one example of a method for manufacturing the back electrode type solar cell shown in Fig. 1.
Fig. 4 is a schematic plan view of one example of a back surface of the back electrode type solar cell shown in Fig. 1.
Figs. 5(a) to (d) are schematic cross-sectional views illustrating one example of a method for manufacturing an interconnection sheet shown in Fig. 1.
Fig. 6 is a schematic plan view of one example of a surface of the interconnection sheet shown in Fig. 1.
Figs. 7(a) to (c) are schematic cross-sectional views illustrating one example of a method for manufacturing the solar cell with the interconnection sheet used in the solar cell module shown in Fig. 1.
Figs. 8(a) and (b) are schematic cross-sectional views illustrating a conventional method for manufacturing a solar cell with an interconnection sheet.
Fig. 9 is a schematic enlarged cross-sectional view of a silver electrode for p type of the solar cell with the interconnection sheet shown in Fig. 8 and therearound.

### DESCRIPTION OF EMBODIMENTS

An embodiment of the present invention will be described hereinafter. In the drawings of the present invention, the same reference characters indicate the same or corresponding portions.

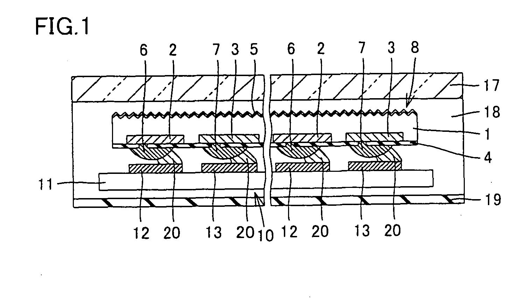

Fig. 1 shows a schematic cross-sectional view of one example of a solar cell module according to the present invention. The solar cell module shown in Fig. 1 has such a configuration that a solar cell with an interconnection sheet configured by disposing a back electrode type solar cell 8 on an interconnection sheet 10 is sealed in a sealant 18 such as ethylene vinyl acetate between a transparent substrate 17 such as a glass substrate and a back film 19 such as a polyester film.

A concave-convex structure such as a texture structure is formed on a light receiving surface of a semiconductor substrate 1 of back electrode type solar cell 8 and an antireflective film 5 is formed to cover the concave-convex structure. A passivation film 4 is also formed on a back surface of semiconductor substrate 1 of back electrode type solar cell 8.

In addition, back electrode type solar cell 8 includes semiconductor substrate 1, a first conduction type impurity diffused region 2 and a second conduction type impurity diffused region 3 formed on the back surface of semiconductor substrate 1, a silver electrode for first conduction type 6 formed to be in contact with first conduction type impurity diffused region 2, and a silver electrode for second conduction type 7 formed to be in contact with second conduction type impurity diffused region 3. Therefore, silver electrode for first conduction type 6 corresponding to first conduction type impurity diffused region 2 and silver electrode for second conduction type 7 corresponding to second conduction type impurity diffused region 3 are formed on the back surface side of semiconductor substrate 1.

Silver electrode for first conduction type 6 and silver electrode for second conduction type 7 on the back surface side of back electrode type solar cell 8 are each shaped to project opposite to semiconductor substrate 1. Each of the width of silver electrode for first conduction type 6 and the width of silver electrode for second conduction type 7 decreases continuously with distance from semiconductor substrate 1. Each of an outer surface of silver electrode for first conduction type 6 and an outer surface of silver electrode for second conduction type 7 has a curved surface like a side surface of a cylinder. Each of the shape of silver electrode for first conduction type 6 and the shape of silver electrode for second conduction type 7 is not limited to this shape. For example, a tip of silver electrode for first conduction type 6 and/or a tip of silver electrode for second conduction type 7 may have a flat shape or a two-humped shape.

It is to be noted that in this example, first conduction type impurity diffused region 2 and second conduction type impurity diffused region 3 are each formed to have a shape of a strip extending to the front surface side and/or the back surface side in the plane of Fig. 1, and first conduction type impurity diffused region 2 and second conduction type impurity diffused region 3 are alternately arranged on the back surface of semiconductor substrate 1 with a predetermined spacing therebetween.

In addition, in this example, silver electrode for first conduction type 6 and silver electrode for second conduction type 7 are also each formed to have a shape of a strip extending to the front surface side and/or the back surface side in the plane of Fig. 1. Silver electrode for first conduction type 6 and silver electrode for second conduction type 7 are formed to be in contact with first conduction type impurity diffused region 2 and second conduction type impurity diffused region 3, along first conduction type impurity diffused region 2 and second conduction type impurity diffused region 3 on the back surface of semiconductor substrate 1, through openings provided in passivation film 4, respectively.

Although silver electrode for first conduction type 6 and silver electrode for second conduction type 7 are used as electrodes of back electrode type solar cell 8 in this example, the electrode is not limited to the silver electrode.

Interconnection sheet 10 includes an insulating base material 11, and a wiring for first conduction type 12 and a wiring for second conduction type 13 formed on a surface of insulating base material 11.

One wiring for first conduction type 12 on insulating base material 11 of interconnection sheet 10 is formed to face one silver electrode for first conduction type 6 on the back surface of back electrode type solar cell 8.

In addition, one wiring for second conduction type 13 on insulating base material 11 of interconnection sheet 10 is formed to face one silver electrode for second conduction type 7 on the back surface of back electrode type solar cell 8.

It is to be noted that in this example, wiring for first conduction type 12 and wiring for second conduction type 13 of interconnection sheet 10 are also each formed to have a shape of a strip extending to the front surface side and/or the back surface side in the plane of Fig. 1.

Silver electrode for first conduction type 6 of back electrode type solar cell 8 8 and wiring for first conduction type 12 of interconnection sheet 10 are electrically and mechanically connected by a tin-containing solder layer 20, and silver electrode for second conduction type 7 of back electrode type solar cell 8 and wiring for second conduction type 13 of interconnection sheet 10 are also electrically and mechanically connected by tin-containing solder layer 20.

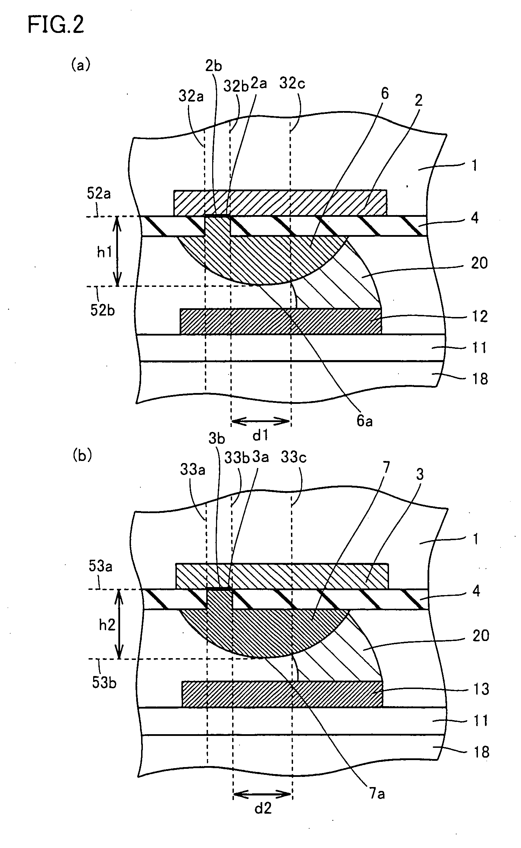

Fig. 2(a) shows a schematic enlarged cross-sectional view of silver electrode for first conduction type 6 of back electrode type solar cell 8 shown in Fig. 1 and therearound. Fig. 2(b) shows a schematic enlarged cross-sectional view of silver electrode for second conduction type 7 of back electrode type solar cell 8 shown in Fig. 1 and therearound.

As shown in Fig. 2(a), a center 2b in a width direction of a first contact region 2a, which is a region of first conduction type impurity diffused region 2 on the back surface of semiconductor substrate 1 with which silver electrode for first conduction type 6 is in contact, is shifted in position from a vertex 6a corresponding to a center in a width direction of silver electrode for first conduction type 6 of back electrode type solar cell 8.

As shown in Fig. 2(a), tin-containing solder layer 20 is not disposed in a region (a region between an imaginary vertical surface 32a and an imaginary vertical surface 32b) corresponding to first contact region 2a, which is a region of first conduction type impurity diffused region 2 with which silver electrode for first conduction type 6 is in contact, and tin-containing solder layer 20 is disposed in a region other than the region (the region between imaginary vertical surface 32a and imaginary vertical surface 32b) corresponding to first contact region 2a.

Silver electrode for first conduction type 6 can have a width of, for example, 200 µm or more and 400 µm or less. Silver electrode for first conduction type 6 can have a thickness of, for example, 10 µm or more and 20 µm or less. Passivation film 4 can have a thickness of, for example, 0.25 µm or more and 0.75 µm or less.

In addition, first contact region 2a can have a width of, for example, 50 µm or more and 100 µm or less. Wiring for first conduction type 12 can have a width of, for example, 300 µm or more and 600 µm or less. Wiring for first conduction type 12 can have a thickness of, for example, 10 µm or more and 50 µm or less.

In addition, the distance between wiring for first conduction type 12 and wiring for second conduction type 13 adjacent thereto can be set to be, for example, 150 µm or more and 300 µm or less. The position shift distance in the width direction of first contact region 2a between center 2b in the width direction of first contact region 2a and vertex 6a corresponding to the center in the width direction of silver electrode for first conduction type 6 can be set to be, for example, 50 µm or more and 200 µm or less.

As shown in Fig. 2(b), a center 3b in a width direction of a second contact region 3a, which is a region of second conduction type impurity diffused region 3 on the back surface of semiconductor substrate 1 with which silver electrode for second conduction type 7 is in contact, is shifted in position from a vertex 7a corresponding to a center in a width direction of silver electrode for second conduction type 7 of back electrode type solar cell 8.

As shown in Fig. 2(b), tin-containing solder layer 20 is not disposed in a region (a region between an imaginary vertical surface 33a and an imaginary vertical surface 33b) corresponding to second contact region 3a, which is a region of second conduction type impurity diffused region 3 with which silver electrode for second conduction type 7 is in contact, and tin-containing solder layer 20 is disposed in a region other than the region (the region between imaginary vertical surface 33a and imaginary vertical surface 33b) corresponding to second contact region 3a.

Silver electrode for second conduction type 7 can have the same level of width and thickness as those of silver electrode for first conduction type 6, for example. Second contact region 3a can have the same level of width as that of first contact region 2a, for example. Wiring for second conduction type 13 can have the same level of width and thickness as those of wiring for first conduction type 12, for example. In addition, the position shift distance in the width direction of second contact region 3a between center 3b in the width direction of second contact region 3a and vertex 7a corresponding to the center in the width direction of silver electrode for second conduction type 7 can be set to be comparable to the position shift distance in the width direction of first contact region 2a between center 2b in the width direction of first contact region 2a and vertex 6a corresponding to the center in the width direction of silver electrode for first conduction type 6, for example.

The width direction of silver electrode for first conduction type 6 herein refers to the direction orthogonal to the longitudinal direction of silver electrode for first conduction type 6, and the width direction of silver electrode for second conduction type 7 refers to the direction orthogonal to the longitudinal direction of silver electrode for second conduction type 7.

In addition, the width direction of first contact region 2a refers to the direction orthogonal to the longitudinal direction of first contact region 2a, and the width direction of second contact region 3a refers to the direction orthogonal to the longitudinal direction of second contact region 3a.

It is to be noted that in the examples shown in Figs. 2(a) and (b), all of the width direction of silver electrode for first conduction type 6, the width direction of silver electrode for second conduction type 7, the width direction of first contact region 2a, and the width direction of second contact region 3a correspond to the horizontal direction in the plane of each of Figs. 2(a) and (b).

As described above, back electrode type solar cell 8 is used in which the center in the width direction of the contact region (first contact region 2a and second contact region 3a) is shifted in position from the center in the width direction of the silver electrode (silver electrode for first conduction type 6 and silver electrode for second conduction type 7), and tin-containing solder layer 20 is disposed in the region other than the region corresponding to the contact region (first contact region 2a and second contact region 3a). As a result, as compared with the conventional structure shown in Figs. 8 and 9, for example, the time that elapses before contact resistance increases due to contact of the silver-tin alloy layer with first contact region 2a and second contact region 3a can be lengthened. Therefore, the reliability of the solar cell module can be ensured for a longer time.

In addition, as shown in Fig. 2(a), a shortest distance d 1 between imaginary vertical surface 32b including an end closest to tin-containing solder layer 20 in the width direction of first contact region 2a and an imaginary vertical surface 32c including an end closest to first contact region 2a in the width direction of tin-containing solder layer 20 (the shortest distance in the width direction between first contact region 2a and tin-containing solder layer 20) is preferably not less than three times as long as a shortest distance h1 in the height direction between an imaginary horizontal surface 52a including first contact region 2a on the back surface of semiconductor substrate 1 and an imaginary horizontal surface 52b including vertex 6a of silver electrode for first conduction type 6 (the shortest distance in the height direction between first contact region 2a and vertex 6a of silver electrode for first conduction type 6). In this case, the time that elapses before contact resistance increases due to contact of the silver-tin alloy layer with first contact region 2a can be further lengthened. Therefore, there is a tendency that the reliability of the solar cell l module can be ensured for a much longer time. It is to be noted that d1 can have a length of, for example, 50 µm or more and 200 µm or less.

In addition, as shown in Fig. 2(b), a shortest distance d2 between imaginary vertical surface 33b including an end closest to tin-containing solder layer 20 in the width direction of second contact region 3a and an imaginary vertical surface 33c including an end closest to second contact region 3a in the width direction of tin-containing solder layer 20 (the shortest distance in the width direction between second contact region 3a and tin-containing solder layer 20) is preferably not less than three times as long as a shortest distance h2 in the height direction between an imaginary horizontal surface 53a including second contact region 3a on the back surface of semiconductor substrate 1 and an imaginary horizontal surface 53b including vertex 7a of silver electrode for second conduction type 7 (the shortest distance in the height direction between second contact region 3a and vertex 7a of silver electrode for second conduction type 7). In this case, the time that elapses before contact resistance increases due to contact of the silver-tin alloy layer with second contact region 3a can be further lengthened. Therefore, there is a tendency that the reliability of the solar cell module can be ensured for a much longer time. It is to be noted that d2 can have a length of, for example, 50 µm or more and 200 µm or less.

It is to be noted that tin-containing solder layer 20 is not particularly limited as long as tin-containing solder layer 20 is formed of tin-containing solder. For example, a layer formed of Sn-Bi-based solder including at least tin and bismuth can be used as tin-containing solder layer 20.

In addition, as shown in Fig. 2(a), for example, in the case where vertex 6a of silver electrode for first conduction type 6 nearest to wiring for first conduction type 12 in the surface region of silver electrode for first conduction type 6 is not in contact with tin-containing solder layer 20, the time that elapses before contact resistance increases due to contact of the silver-tin alloy layer with first contact region 2a can be lengthened as compared with the conventional structure. Therefore, the reliability of the solar cell l module can be ensured for a longer time.

In addition, as shown in Fig. 2(b), for example, as for not only silver electrode for first conduction type 6 but also silver electrode for second conduction type 7, vertex 7a of silver electrode for second conduction type 7 nearest to wiring for second conduction type 13 in the surface region of silver electrode for second conduction type 7 is not in contact with tin-containing solder layer 20, whereby the reliability of the solar cell module can be further significantly increased.

In addition, as shown in Fig. 2(a), for example, wiring for first conduction type 12 may be arranged to be shifted in position from silver electrode for first conduction type 6 by arranging tin-containing solder 20 to be shifted in position from silver electrode for first conduction type 6. It is to be noted that in the example shown in Fig. 2(a), the position of center 2b in the width direction of first contact region 2a is shifted opposite to the side where tin-containing solder layer 20 is disposed.

In addition, as shown in Fig. 2(b), for example, wiring for second conduction type 13 may be arranged to be shifted in position from silver electrode for second conduction type 7 by arranging tin-containing solder 20 to be shifted in position from silver electrode for second conduction type 7. It is to be noted that in the example shown in Fig. 2(b), the position of center 3b in the width direction of second contact region 3a is shifted opposite to the side where tin-containing solder layer 20 is disposed.

When the distance between wiring for first conduction type 12 and wiring for second conduction type 13 adjacent thereto is short, silver electrode for first conduction type 6 is preferably arranged to face wiring for first conduction type 12, and further, silver electrode for second conduction type 7 is more preferably arranged to face wiring for second conduction type 13.

By making smaller a region where silver electrode for second conduction type 7 faces wiring for first conduction type 12 and/or a region where silver electrode for first conduction type 6 faces wiring for second conduction type 13, an influence of ion migration and the like of electrode components due to potential difference between silver electrode for first conduction type 6 and silver electrode for second conduction type 7 can be reduced.

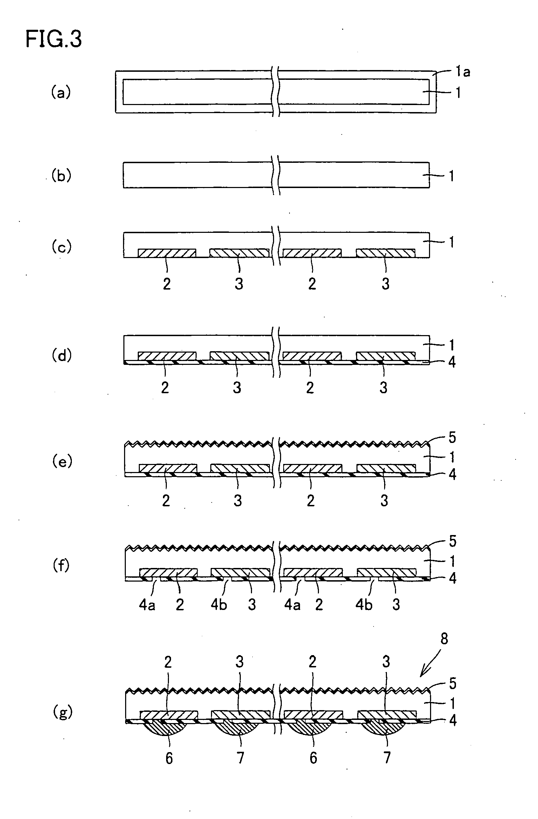

One example of a method for manufacturing back electrode type solar cell 8 shown in Fig. 1 will be described hereinafter with reference to schematic cross-sectional views in Figs. 3(a) to (g).

First, as shown in Fig. 3(a), semiconductor substrate 1 having a slice damage 1 a formed on the surface of semiconductor substrate 1 is prepared by, for example, slicing from an ingot. A silicon substrate made of polycrystalline silicon, monocrystalline silicon or the like and having an conduction type of either n type or p type can, for example, be used as semiconductor substrate 1.

Next, as shown in Fig. 3(b), slice damage 1a on the surface of semiconductor substrate 1 is removed. When semiconductor substrate 1 is formed of, for example, the above silicon substrate, slice damage 1a is removed by, for example, etching the surface of the above sliced silicon substrate with mixed acid of hydrofluoric aqueous solution and nitric acid, alkali aqueous solution such as sodium hydroxide, or the like.

The size and the shape of semiconductor substrate 1 after removal of slice damage 1 a are not particularly limited. Semiconductor substrate 1 can, however, have a thickness of, for example, 100 µm or more and 500 µm or less, and particularly preferably, approximately 200 µm.

Next, as shown in Fig. 3(c), first conduction type impurity diffused region 2 and second conduction type impurity diffused region 3 are each formed on the back surface of semiconductor substrate 1. First conduction type impurity diffused region 2 can be formed using, for example, a method such as vapor-phase diffusion with gas including a first conduction type impurity or application diffusion in which heat treatment is performed after a paste including the first conduction type impurity is applied. Second conduction type impurity diffused region 3 can be formed using, for example, a method such as vapor-phase diffusion with gas including a second conduction type impurity or application diffusion in which heat treatment is performed after a paste including the second conduction type impurity is applied.

First conduction type impurity diffused region 2 is not particularly limited as long as first conduction type impurity diffused region 2 includes the first conduction type impurity and shows the conduction type of either n type or p type. It is to be noted that an n-type impurity such as, for example, phosphorus can be used as the first conduction type impurity when the first conduction type is the n type, and a p-type impurity such as, for example, boron or aluminum can be used when the first conduction type is the p type.

In addition, second conduction type impurity diffused region 3 is not particularly limited as long as second conduction type impurity diffused region 3 includes the second conduction type impurity and shows the conduction type opposite to that of first conduction type impurity diffused region 2. It is to be noted that an n-type impurity such as, for example, phosphorus can be used as the second conduction type impurity when the second conduction type is the n type, and a p-type impurity such as, for example, boron or aluminum can be used when the second conduction type is the p type.

It is to be noted that the first conduction type may be n type or p type and the second conduction type may only be opposite to the first conduction type. In other words, when the first conduction type is the n type, the second conduction type is the p type, and when the first conduction type is the p type, the second conduction type is the n type.

When the first conduction type is the n type, gas including the n-type impurity such as, for example, phosphorus like POCl₃ can be used as the gas including the first conduction type impurity. When the first conduction type is the p type, gas including the p-type impurity such as, for example, boron like BBr₃ can be used.

When the second conduction type is the n type, gas including the n-type impurity such as, for example, phosphorus like POCl₃ can be used as the gas including the second conduction type impurity. When the second conduction type is the p type, gas including the p-type impurity such as, for example, boron like BBr₃ can be used.

Next, as shown in Fig. 3(d), passivation film 4 is formed on the back surface of semiconductor substrate 1. Passivation film 4 can be formed using, for example, a method such as a thermal oxidation method or a plasma CVD (Chemical Vapor Deposition) method.

An oxide silicon film, a nitride silicon film, a stacked film of oxide silicon films and nitride silicon films or the like can, for example, be used as passivation film 4, although passivation film 4 is not limited thereto.

Passivation film 4 can preferably have a thickness of, for example, 0.05 µm or more and 1 µm or less, and particularly preferably, approximately 0.2 µm.

Next, as shown in Fig. 3(e), the concave-convex structure such as the texture structure is formed on the entire light receiving surface of semiconductor substrate 1, and then, antireflective film 5 is formed on the concave-convex structure.

The texture structure can be formed by, for example, etching the light receiving surface of semiconductor substrate 1. When semiconductor substrate 1 is formed of, for example, the silicon substrate, the texture structure can be formed by etching the light receiving surface of semiconductor substrate 1 using, for example, an etchant made by adding isopropyl alcohol to an alkali aqueous solution such as sodium hydroxide or potassium hydroxide and heating the solution to, for example, 70°C or higher and 80°C or lower.

In addition, antireflective film 5 can be formed using, for example, the plasma CVD method and the like. A nitride silicon film or the like can, for example, be used as antireflective film 5, although antireflective film 5 is not limited thereto.

Next, as shown in Fig. 3(f), a contact hole 4a and a contact hole 4b are formed by removing a part of passivation film 4 on the back surface of semiconductor substrate 1. Contact hole 4a is formed to expose at least a part of a surface of first conduction type impurity diffused region 2, and contact hole 4b is formed to expose at least a part of a surface of second conduction type impurity diffused region 3.

It is to be noted that contact hole 4a and contact hole 4b can be formed using, for example, a method of using a photolithography technique to form, on passivation film 4, a resist pattern having openings at portions corresponding to the portions where contact hole 4a and contact hole 4b are to be formed, and then, removing passivation film 4 from the openings of the resist pattern by etching and the like, or a method of applying an etching paste to portions of passivation film 4 corresponding to the portions where contact hole 4a and contact hole 4b are to be formed, and then, applying heat and removing passivation film 4 by etching.

Next, as shown in Fig. 3(g), silver electrode for first conduction type 6 that is in contact with first conduction type impurity diffused region 2 through contact hole 4a as well as silver electrode for second conduction type 7 that is in contact with second conduction type impurity diffused region 3 through contact hole 4b are formed.

It is to be noted that silver electrode for first conduction type 6 and silver electrode for second conduction type 7 can be formed by, for example, applying a silver paste to be in contact with first conduction type impurity diffused region 2 through contact hole 4a and to be in contact with second conduction type impurity diffused region 3 through contact hole 4b, and then, baking the silver paste, respectively.

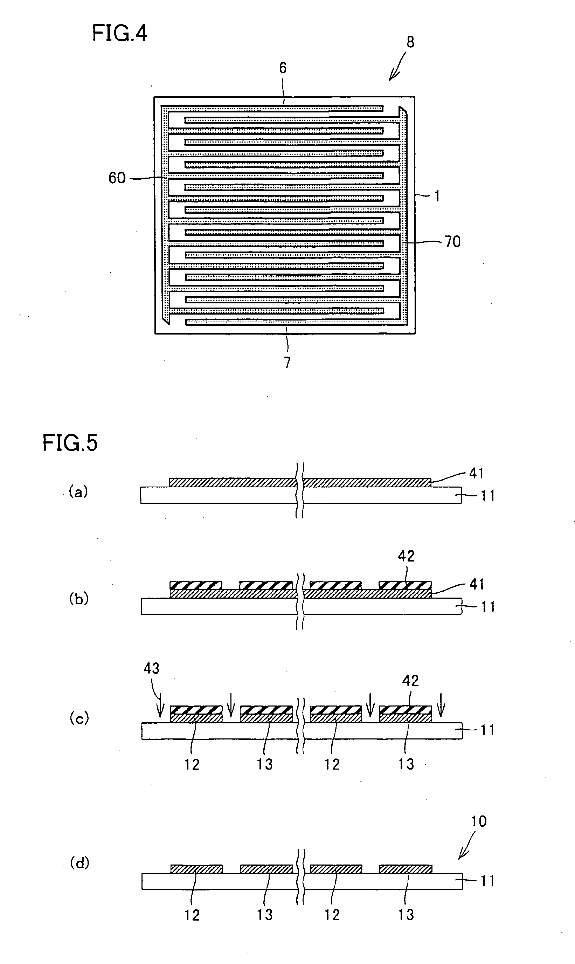

Fig. 4 shows a schematic plan view of one example of the back surface of back electrode type solar cell 8 shown in Fig. 1 fabricated as described above. On the back surface of back electrode type solar cell 8, silver electrode for first conduction type 6 and silver electrode for second conduction type 7 are each formed to have a shape of a strip. A plurality of strip-shaped silver electrodes for first conduction type 6 are each connected to one strip-shaped collector electrode for first conduction type 60, and a plurality of strip-shaped silver electrodes for second conduction type 7 are each connected to one strip-shaped collector electrode for second conduction type 70. It is to be noted that in this example, collector electrode for first conduction type 60 is formed to extend in the direction perpendicular to the longitudinal direction of strip-shaped silver electrode for first conduction type 6, and collector electrode for second conduction type 70 is formed to extend in the direction perpendicular to the longitudinal direction of strip-shaped silver electrode for second conduction type 7.

Therefore, on the back surface of back electrode type solar cell 8 having a configuration shown in Fig. 4, one collector electrode for first conduction type 60 and the plurality of silver electrodes for first conduction type 6 form one comb-shaped electrode, and one collector electrode for second conduction type 70 and the plurality of silver electrodes for second conduction type 7 form one comb-shaped electrode. Silver electrode for first conduction type 6 and silver electrode for second conduction type 7 corresponding to teeth of these comb-shaped electrodes are arranged to face and engage with each other. One strip-shaped first conduction type impurity diffused region 2 is arranged on the back surface portion of semiconductor substrate 1 with which strip-shaped silver electrode for first conduction type 6 is in contact, and one strip-shaped second conduction type impurity diffused region 3 is arranged on the back surface portion of semiconductor substrate 1 with which strip-shaped silver electrode for second conduction type 7 is in contact.

One example of a method for manufacturing interconnection sheet 10 shown in Fig. 1 will be described hereinafter with reference to schematic cross-sectional views in Figs. 5(a) to (d).

First, as shown in Fig. 5(a), a conductive layer 41 is formed on the surface of insulating base material 11. A substrate made of resin such as polyester, polyethylene naphthalate or polyimide can, for example, be used as insulating base material 11, although insulating base material 11 is not limited thereto.

Insulating base material 11 can have a thickness of, for example, 10 µm or more and 200 µm or less, and particularly preferably, approximately 25 µm.

A layer made of metal such as copper can, for example, be used as conductive layer 41, although conductive layer 41 is not limited thereto.

Next, as shown in Fig. 5(b), a resist 42 is formed on conductive layer 41 on the surface of insulating base material 11. Resist 42 is shaped to have an opening at a portion other than a portion where a wiring of interconnection sheet 10 such as wiring for first conduction type 12 and wiring for second conduction type 13 is to be left. A conventionally known resist can, for example, be used as resist 42, and a resist obtained by curing a resin applied at a predetermined position using a method such as screen printing, dispenser application or ink jet application can be used, for example.

Next, as shown in Fig. 5(c), conductive layer 41 is patterned by removing, in the direction of an arrow 43, conductive layer 41 located at a portion where conductive layer 41 is exposed from resist 42, and the wiring of interconnection sheet 10 such as wiring for first conduction type 12 and wiring for second conduction type 13 is formed by remaining conductive layer 41.

Conductive layer 41 can be removed by, for example, wet etching and the like with an acid or alkali solution.

Next, as shown in Fig. 5(d), resist 42 is all removed from a surface of wiring for first conduction type 12 and a surface of wiring for second conduction type 13. Interconnection sheet 10 is thus fabricated.

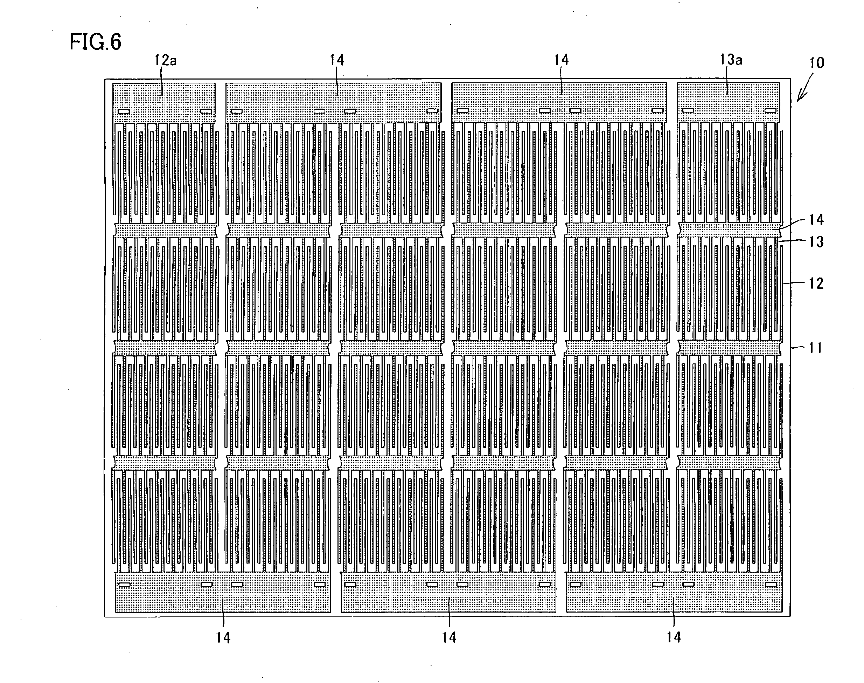

Fig. 6 shows a schematic plan view of one example of a surface of interconnection sheet 10 fabricated as described above. On the surface of insulating substrate 11 of interconnection sheet 10, wiring for first conduction type 12 and wiring for second conduction type 13 are each formed to have a shape of a strip. A strip-shaped connecting wiring 14 is formed on the front surface of insulating base material 11 of interconnection sheet 10, and connecting wiring 14 electrically connects wiring for first conduction type 12 and wiring for second conduction type 13. It is to be noted that connecting wiring 14 can, for example, be formed by remaining conductive layer 41, similarly to wiring for first conduction type 12 and wiring for second conduction type 13.

With such a configuration, adjacent wiring for first conduction type 12 and wiring for second conduction type 13 are electrically connected by connecting wiring 14, except comb-shaped wiring for first conduction type 12a and comb-shaped wiring for second conduction type 13a that are located at opposing ends of interconnection sheet 10. Thus, back electrode type solar cells 8 disposed to be adjacent to each other on interconnection sheet 10 are electrically connected with each other. Therefore, back electrode type solar cells 8 disposed on interconnection sheet 10 are all electrically connected in series.

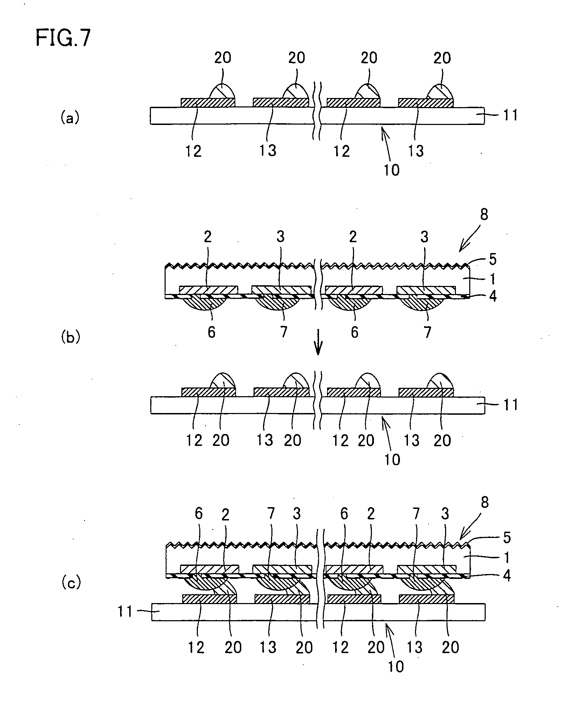

One example of a method for manufacturing the solar cell with the interconnection sheet used in the solar cell module shown in Fig. 1 will be described hereinafter with reference to schematic cross-sectional views in Figs. 7(a) to (c).

First, as shown in Fig. 7(a), tin-containing solder layer 20 is formed on the surface of each of wiring for first conduction type 12 and wiring for second conduction type 13 of interconnection sheet 10 fabricated as described above.

Tin-containing solder layer 20 can be formed by selectively applying tin-containing solder only on one end side on the surface of each of wiring for first conduction type 12 and wiring for second conduction type 13. In addition, the tin-containing solder for forming tin-containing solder layer 20 can be selectively applied using, for example, a method such as screen printing, dispenser application or ink jet application.

Tin-containing solder layer 20 can also be formed by, for example, disposing a solder resist on a surface region of each of wiring for first conduction type 12 and wiring for second conduction type 13 where tin-containing solder layer 20 is not disposed, and then, applying the tin-containing solder.

Next, as shown in Fig. 7(b), back electrode type solar cell 8 is disposed on interconnection sheet 10.

As shown in Fig. 7(c), for example, back electrode type solar cell 8 is disposed on interconnection sheet 10 such that silver electrode for first conduction type 6 of back electrode type solar cell 8 is disposed over wiring for first conduction type 12 of interconnection sheet 10 and silver electrode for second conduction type 7 of back electrode type solar cell 8 is disposed over wiring for second conduction type 13 of interconnection sheet 10.

At this time, due to pressure applied toward the interconnection sheet 10 side by each of silver electrode for first conduction type 6 and silver electrode for second conduction type 7 of back electrode type solar cell 8, tin-containing solder layer 20 extends on the surface of wiring for first conduction type 12 and on the surface of wiring for second conduction type 13 of interconnection sheet 10.

Thereafter, tin-containing solder layer 20 is cooled and solidified. As a result, silver electrode for first conduction type 6 of back electrode type solar cell 8 and wiring for first conduction type 12 of interconnection sheet 10 are electrically and mechanically connected, and silver electrode for second conduction type 7 of back electrode type solar cell 8 and wiring for second conduction type 13 of interconnection sheet 10 are electrically and mechanically connected. The solar cell with the interconnection sheet having a structure shown in Fig. 7(c) is thus fabricated.

Then, as shown in Fig. 1, for example, the solar cell with the interconnection sheet fabricated as described above is sandwiched between transparent substrate 17 such as a glass substrate including sealant 18 such as ethylene vinyl acetate and back film 19 such as a polyester film including sealant 18, and back electrode type solar cell 8 constituting the solar cell with the interconnection sheet is sealed in sealant 18. The solar cell module shown in Fig. 1 is thus fabricated.

It is to be noted that the concept of the back electrode type solar cell according to the present invention includes not only the above-mentioned configuration in which the silver electrode for first conduction type and the silver electrode for second conduction type are both formed only on one surface side (on the back surface side) of the semiconductor substrate but also a so-called back contact type solar cell (a solar cell configured such that current is taken out from the back surface side opposite to the light receiving surface side of the solar cell) such as an MWT (Metal Wrap Through) cell (a solar cell configured such that a part of an electrode is arranged in a through hole provided in a semiconductor substrate).

In addition, the concept of the solar cell with the interconnection sheet according to the present invention also includes not only a configuration in which a plurality of back electrode type solar cells are disposed on the interconnection sheet but also a configuration in which one back electrode type solar cell is disposed on the interconnection sheet.

In the above, tin-containing solder layer 20 is formed in a portion between silver electrode for first conduction type 6 and wiring for first conduction type 12 as well as a portion between silver electrode for second conduction type 7 and wiring for second conduction type 13. In the present invention, however, tin-containing solder layer 20 may only be formed in at least one of the portion between silver electrode for first conduction type 6 and wiring for first conduction type 12 as well as the portion between silver electrode for second conduction type 7 and wiring for second conduction type 13.

It should be understood that the embodiment disclosed herein is illustrative and not limitative in any respect. The scope of the present invention is defined by the terms of the claims, rather than the description above, and is intended to include any modifications within the scope and meaning equivalent to the terms of the claims.

### INDUSTRIAL APPLICABILITY

The present invention can be used in a back electrode type solar cell capable of ensuring the reliability of a solar cell module for a longer time, a solar cell with an interconnection sheet, and a solar cell module.

### REFERENCE SIGNS LIST

1 semiconductor substrate; 1a slice damage; 2 first conduction type impurity diffused region; 2a first contact region; 2b center; 3 second conduction type impurity diffused region; 3a second contact region; 3b center; 4 passivation film; 4a contact hole; 4b contact hole; 5 antireflective film; 6 silver electrode for first conduction type; 6a vertex; 7 silver electrode for second conduction type; 7a vertex; 8, 80 back electrode type solar cell; 10, 100 interconnection sheet; 11 insulating base material; 12, 12a wiring for first conduction type; 13, 13a wiring for second conduction type; 17 transparent substrate; 18 sealant; 19 back film; 20 tin-containing solder layer; 32a, 32b, 32c, 33a, 33b, 33c imaginary vertical surface; 41 conductive layer; 42 resist; 43 arrow; 52a, 52b, 53a, 53b imaginary horizontal surface; 60 collector electrode for first conduction type; 70 collector electrode for second conduction type; 101 n-type silicon substrate; 102 p+ layer; 103 n+ layer; 106 silver electrode for p type; 107 silver electrode for n type; 111 glass epoxy board; 112 p wiring; 113 n wiring; 119 solder; 121 alloy layer

## Claims

1. A back electrode type solar cell (8), comprising:
a semiconductor substrate (1); and
an electrode for first conduction type (6) and an electrode for second conduction type (7) disposed on one surface side of said semiconductor substrate (1),
a center (2b) in a width direction of a first contact region (2a), which is a region of said semiconductor substrate (1) with which said electrode for first conduction type (6) is in contact, being shifted in position from a center in a width direction of said electrode for first conduction type (6).

2. The back electrode type solar cell (8) according to claim 1, wherein
a center (3b) in a width direction of a second contact region (3a), which is a region of said semiconductor substrate (1) with which said electrode for second conduction type (7) is in contact, is shifted in position from a center in a width direction of said electrode for second conduction type (7).

3. A solar cell with an interconnection sheet, comprising:
a back electrode type solar cell (8); and
an interconnection sheet (10),
said back electrode type solar cell (8) including a semiconductor substrate (1), and an electrode for first conduction type (6) and an electrode for second conduction type (7) disposed on one surface side of said semiconductor substrate (1),
said interconnection sheet (10) including an insulating base material (1 1), and a wiring for first conduction type (12) and a wiring for second conduction type (13) disposed on one surface side of said insulating base material (11),
a tin-containing solder layer (20) being disposed in a region other than a region corresponding to at least one of a first contact region (2a), which is a region of said semiconductor substrate (1) with which said electrode for first conduction type (6) is in contact, and a second contact region (3a), which is a region of said semiconductor substrate (1) with which said electrode for second conduction type (7) is in contact.

4. The solar cell with the interconnection sheet according to claim 3, wherein a shortest distance in a width direction between said first contact region (2a) and said tin-containing solder layer (20) is not less than three times as long as a shortest distance in a height direction between said first contact region (2a) and a vertex (6a) of said silver electrode for first conduction type (6).

5. The solar cell with the interconnection sheet according to claim 3 or 4,
wherein
a shortest distance in a width direction between said second contact region (3a) and said tin-containing solder layer (20) is not less than three times as long as a shortest distance in a height direction between said second contact region (3a) and a vertex (7a) of said silver electrode for second conduction type (7).

6. A solar cell with an interconnection sheet, comprising:
a back electrode type solar cell (8); and
an interconnection sheet (10),
said back electrode type solar cell (8) including a semiconductor substrate (1), and an electrode for first conduction type (6) and an electrode for second conduction type (7) disposed on one surface side of said semiconductor substrate (1),
said interconnection sheet (10) including an insulating base material (11), and a wiring for first conduction type (12) and a wiring for second conduction type (13) disposed on one surface side of said insulating base material (11),
a center in a width direction of a tin-containing solder layer (20) that is in contact with said electrode for first conduction type (6) and said electrode for second conduction type (7) being shifted in position from a center in a width direction of at least one of the electrodes (6, 7).

7. The solar cell with the interconnection sheet according to claim 6, wherein the center in the width direction of said tin-containing solder layer (20) that is in contact with said electrode for first conduction type (6) is shifted in position from the center in the width direction of said electrode for first conduction type (6), and a position of a center (2b) in a width direction of a first contact region (2a), which is a region of said semiconductor substrate (1) that is in contact with said electrode for first conduction type (6), is shifted opposite to said tin-containing solder layer (20).

8. The solar cell with the interconnection sheet according to claim 6 or 7,
wherein
the center in the width direction of said tin-containing solder layer (20) that is in contact with said electrode for second conduction type (7) is shifted in position from the center in the width direction of said electrode for second conduction type (7), and a position of a center (3b) in a width direction of a second contact region (3a), which is a region of said semiconductor substrate (1) that is in contact with said electrode for second conduction type (7), is shifted opposite to said tin-containing solder layer (20).

9. The solar cell with the interconnection sheet according to any one of claims 3 to 8, wherein
said tin-containing solder layer (20) includes at least tin and bismuth.

10. A solar cell module including the solar cell with the interconnection sheet as recited in any one of claims 3 to 9.
